# EUROPEAN PATENT APPLICATION

(11) **EP 3 780 317 A1**
(43) Date of publication of application: **17.02.2021**
(21) Application number: 18912022.3
(22) Date of filing: 26.03.2018
(51) Int. Cl.: H02J 7/00

(54) **POWER STORAGE CONTROL DEVICE, POWER STORAGE SYSTEM AND CONTROL METHOD**

(71) Applicant: KABUSHIKI KAISHA TOSHIBA, Minato-ku Tokyo 105-8001 (JP); Toshiba Energy Systems & Solutions Corporation, Saiwai-ku Kawasaki-shi Kanagawa 2120013 (JP)
(72) Inventor: MONDEN, Yukitaka, Tokyo 105-8001 (JP); EGAWA, Masanori, Kawasaki-shi, Kanagawa 212-0013 (JP); KOBAYASHI, Takenori, Kawasaki-shi, Kanagawa 212-0013 (JP)
(74) Representative: Moreland, David
(86) International application number: PCT/JP2018/012203
(87) International publication number: WO 2019/186659

(57) **Abstract**

A power storage control device according to an embodiment is used for a power storage system in which a large-capacity storage battery system including a first power storage device and a high-output storage battery system including a second power storage device are combined. The power storage control device includes: a deterioration state detecting unit configured to detect respective deterioration states of the first power storage device and the second power storage device; a demanded-power amount detecting unit configured to detect an amount of demanded power, the amount of demanded power being an amount of power that the power storage system is requested to be charged or discharged with; and an allocation setting unit configured to, based on the deterioration states of the first power storage device and the second power storage device and the amount of demanded power, set respective amounts of power to be allocated to the first power storage device and the second power storage device. Thus, in the power storage system in which the large-capacity storage battery system and the high-output storage battery system are combined, the power storage control device can facilitate extension of the lifetime of the power storage system as a whole by controlling the charge/discharge capacities of the large-capacity storage battery system and the high-output storage battery system in such a manner that degradation states in the storage battery systems are uniform.

## Description

### FIELD

The present invention relates to a power storage control device, a power storage system, and a control method.

### BACKGROUND

Conventionally, there has been proposed a technique by which, so that a power storage system having a large capacity can operate for the purpose of frequency control that needs power at a high output level, a large-capacity storage battery system having a large capacity but providing relatively low output and a high-output storage battery system providing high output but having a relatively small capacity are installed in combination, the current respective state-of-charge (SOC) values of the large-capacity storage battery system and the high-output storage battery system are acquired, and power needed for the frequency-control operation is allocated to the large-capacity storage battery system and the high-output storage battery system in accordance with the respective SOC values (for example, see Patent Literature 1).

### CITATION LIST

### Patent Literature

Patent literature 1: Japanese Patent Application Laid-open No. 2017-046440

### SUMMARY OF THE INVENTION

### Problem to be Solved by the Invention

However, when the above configuration is employed, it is likely that only a specific one of the large-capacity storage battery system and the high-output storage battery system may excessively operate. Therefore, there is a risk that the storage battery system that has been caused to excessively operate deteriorates faster than the other storage battery system.

The present invention has been made in view of the above inconvenience and is directed to providing a power storage control device, a power storage system, and a control method that are capable of, in the power storage system in which a large-capacity storage battery system and a high-output storage battery system are combined, facilitating extension of the lifetime of the power storage system as a whole by controlling, in such a manner as to equalize degradation states in the storage battery system, amounts of power with which the large-capacity storage battery system and the high-output storage battery system are charged or discharged.

### Means for Solving Problem

According to an embodiment, a power storage control device is used for a power storage system in which a large-capacity storage battery system including a first power storage device and a high-output storage battery system including a second power storage device are combined. The power storage control device includes: a deterioration state detecting unit configured to detect respective deterioration states of the first power storage device and the second power storage device; a demanded-power amount detecting unit configured to detect an amount of demanded power, the amount of demanded power being an amount of power that the power storage system is requested to be charged or discharged with; and an allocation setting unit configured to, based on the deterioration states of the first power storage device and the second power storage device and the amount of demanded power, set respective amounts of power to be allocated to the first power storage device and the second power storage device.

### BRIEF DESCRIPTION OF DRAWINGS

FIG. 1 is a schematic configuration block diagram of a power storage system in a first embodiment.
FIG. 2 is a processing flowchart for the power storage system in the first embodiment.
FIG. 3 is a diagram explaining the relations of the discharging capacity of the large-capacity storage battery system and the discharging capacity of the high-output storage battery system and an amount of demanded power.
FIG. 4 is a schematic configuration block diagram of a power storage system in a second embodiment.
FIG. 5 is a processing flowchart for the power storage system in the second embodiment.

### DETAILED DESCRIPTION

The following describes preferred embodiments with reference to the drawings.

### First Embodiment

A first embodiment is described first.

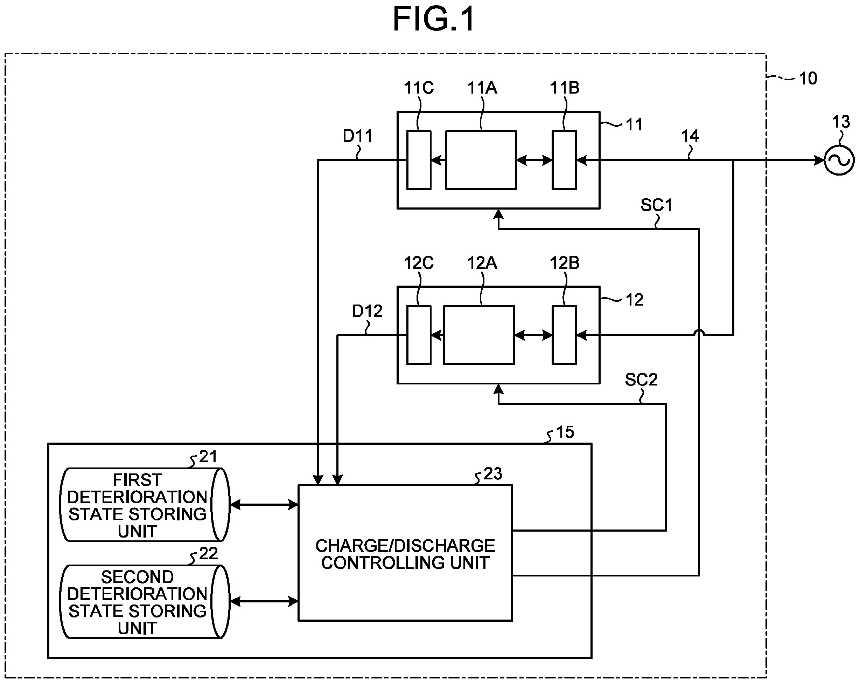

FIG. 1 is a schematic configuration block diagram of a power storage system in the first embodiment.

A power storage system 10 includes: a large-capacity storage battery system 11 having a relatively large capacity and providing relatively low output; a high-output storage battery system 12 having a relatively small capacity and providing relatively high output; a power line 14 for supplying power (what is called system interconnection) to a commercial system 13 or receiving power from the commercial system 13; and a power storage control device 15 for controlling the large-capacity storage battery system 11 and the high-output storage battery system 12 in conjunction with each other.

In the above configuration, the large-capacity storage battery system 11 includes: a power storage device 11A of a large-capacity type capable of being charged and discharged with power that is needed for long-time power adjustment; a power converter 11B; and a state detecting unit 11C.

As the power storage device 11A of the large-capacity type, an energy storage device that stores energy in the form of a flywheel, heat, or hydrogen may be used while mainstream examples thereof are various kinds of secondary battery.

The power converter 11B charges and discharges the power storage device 11A.

The state detecting unit 11C detects the power storage capacity, the temperature, the input and output currents, and the input and output voltages of the large-capacity storage battery system 11, and the state (such as the state of charge (SOC) or the state of health (SOH)) of the power storage device 11A and outputs the detected information as first state detection data D11.

The high-output storage battery system 12 includes: a power storage device 12A of a high-input/output type capable of being charged and discharged with power that is needed for short-time power adjustment; and a power converter 12B.

As the power storage device 12A of the high-input/output type, an energy storage device such as an electric double layer capacitor, a flywheel, or a superconducting magnetic energy storage (SMES) may be used while mainstream examples thereof are various kinds of secondary battery as in the case of a power storage device of the large-capacity type.

The power converter 12B charges and discharges the power storage device 12A.

A state detecting unit 12C detects the power storage capacity, the temperature, the input and output currents, and the input and output voltages of the high-output storage battery system 12, and the state (such as the SOC or the SOH) of the power storage device 12A and outputs the detected information as second state detection data D12.

When the output of the large-capacity storage battery system 11 and the output of the high-output storage battery system 12 are alternating currents, these output alternating currents are coupled by the power line 14, and the power line 14 is connected to the commercial system 13.

The power storage control device 15 includes: a first deterioration state storing unit 21 that is capable of storing therein control-use information such as voltage information and temperature information and deterioration state information such as a battery capacity and an internal resistance value corresponding to the large-capacity storage battery system 11 in the form of a database, and outputting them as first deterioration state data D21; a second deterioration state storing unit 22 that is capable of storing therein voltage information, temperature information, and a deterioration state obtained from a battery capacity, internal resistance, or the like corresponding to the high-output storage battery system 12 in the form of a database, and outputting them as second deterioration state data D22; and a charge/discharge controlling unit 23 that controls the large-capacity storage battery system 11 and the high-output storage battery system 12 in conjunction with each other by generating and outputting a first control signal SC1 and a second control signal SC2 based on actual state information on the large-capacity storage battery system 11, actual state information on the high-output storage battery system 12, and the control-use information and the deterioration state information that have been stored in the first deterioration state storing unit 21 and the second deterioration state storing unit 22.

The above description adopts a configuration in which the power storage control device 15 controls both of the large-capacity storage battery system 11 and the high-output storage battery system 12; however, it is alternatively possible to provide a first charge control device configured to control the large-capacity storage battery system 11 based on information from the high-output storage battery system 12 and a second charge control device configured to control the high-output storage battery system 12 based on information from the large-capacity storage battery system 11 and install the first charge control device and the second charge control device in physically remote locations.

The following describes the operation of the power storage system 10.

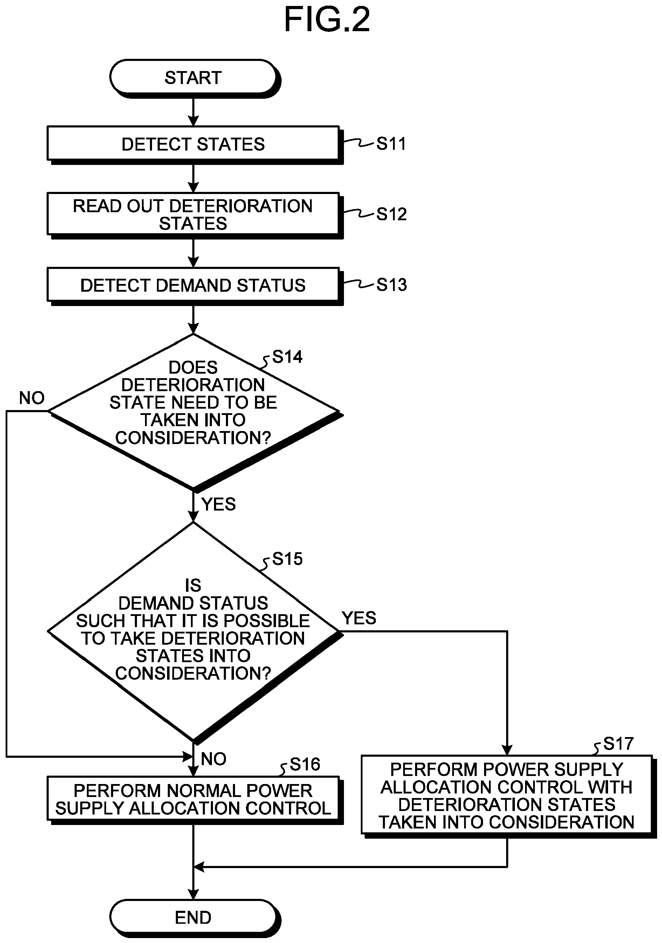

FIG. 2 is a processing flowchart for the power storage system in the first embodiment.

At the start, state detection processing is performed in the power storage system 10 (step S11).

In the state detection processing, the state detecting unit 11C detects the power storage capacity, the temperature, the input and output currents, and the input and output voltages of the large-capacity storage battery system 11, and the state (such as the SOC or the SOH) of the power storage device 11A and outputs them as the first state detection data D11 to the charge/discharge controlling unit 23.

Likewise, the state detecting unit 12C detects the power storage capacity, the temperature, the input and output currents, and the input and output voltages of the high-output storage battery system 12, and the state (such as the SOC or the SOH) of the power storage device 12A and outputs them as the second state detection data D12 to the charge/discharge controlling unit 23.

As a result of this processing, the charge/discharge controlling unit 23 detects the state of the system interconnection with the commercial system 13 or the state of charge of the large-capacity storage battery system 11 or the high-output storage battery system 12 in connection with power supply from the commercial system 13.

The charge/discharge controlling unit 23 then functions as a deterioration state detecting unit and, at a certain timing, based on the history of the first state detection data D11 and the history of the second state detection data D12, updates the first deterioration state data D21 to be stored in the first deterioration state storing unit 21 corresponding to the large-capacity storage battery system 11 and the second deterioration state data D22 to be stored in the second deterioration state storing unit 22 corresponding to the high-output storage battery system 12. That is, the first deterioration state storing unit 21 and the second deterioration state storing unit 22 are updated to the most recent states at every certain timing.

In this context, detection of the deterioration state is described.

As parameters for detection (calculation) of the deterioration state, the amount of storable energy, the internal resistance value, charge-discharge cycles, the stay duration rates for corresponding SOC ranges, the stay duration rates for corresponding temperature ranges, and the like of the power storage device 11A or the power storage device 12A are listed.

The above parameters are described in detail.

First, for example, when storable energy is used as the parameter in calculation of the deterioration state, the storable energy is measured in units of watt-hour (Wh) or ampere-hour (Ah) in the power storage devices 11A and 12A that are configured as secondary batteries. In the power storage devices 11A and 12A that are configured as flywheels, the storable energy is measured in units of number of revolutions. In the power storage devices 11A and 12A that are configured as hydrogen power storage devices, the storable energy is measured in units of pressure.

It generally goes that: the amount of storable energy tends to decrease from an initial characteristic as the deterioration of a power storage system progresses; and, if the amount of storable energy has decreased to a certain amount, the power storage device is determined to have reached the end of the lifetime thereof.

For that reason, the charge/discharge controlling unit 23 functions as an allocation setting unit, monitors the individual amounts of storable energy of the power storage device 11A and the power storage device 12A, and performs control in such a manner as to, so as to equalize the expected periods that remain until the ends of the lifetimes thereof, adjust the amount of power with which the power storage device 11A and the power storage device 12A are charged and discharged (in such a manner as to, instead of equalizing burdens thereon, change the burden ratio therebetween so as to equalize the periods that remain until the ends of the lifetimes thereof).

Next, when the internal resistance value is used as the parameter in calculation of the deterioration state, it generally goes that: an internal resistance value tends to increase from an initial characteristic as the deterioration of a corresponding power storage system progresses; and therefore, if the internal resistance value has increased to a certain value, the power storage device is determined to have reached the end of the lifetime thereof.

For that reason, the charge/discharge controlling unit 23 monitors the individual internal resistance values of the power storage device 11A and the power storage device 12A, and performs control in such a manner as to, so as to equalize periods that remain until the ends of the lifetimes thereof, adjust the amounts of power with which the power storage device 11A and the power storage device 12A are charged and discharged (in such a manner as to, instead of equalizing burdens thereon, change the burden ratio therebetween so as to equalize the periods that remain until the ends of the lifetimes thereof).

Next, when the charge-discharge cycle is used as the parameter in calculation of the deterioration state, it generally goes that: the deterioration of a power storage system accelerates as the number of charge-discharge cycles experienced thereby is higher; and therefore, if the number of charge-discharge cycles has reached a certain number, the power storage device is determined to have reached the end of the lifetime thereof.

For that reason, the charge/discharge controlling unit 23 functions as the allocation setting unit, monitors the individual numbers of charge-discharge cycles experienced by the power storage device 11A and the power storage device 12A, and performs control in such a manner as to, so as to equalize the expected periods that remain until the ends of the lifetimes thereof, adjust the numbers of charge-discharge cycles to be experienced by the power storage device 11A and the power storage device 12A (in such a manner as to, instead of equalizing burdens thereon, change the burden ratio therebetween so as to equalize the periods that remain until the ends of the lifetimes thereof).

Next, when the stay duration rates for corresponding SOC ranges are used as the parameters in calculation of the deterioration state, it is generally known that a lifetime varies depending on stay duration rates for corresponding SOC ranges (levels).

Specifically, for example, a secondary battery to which voltage is applied in a floating state for one year up to the SOC level of 100% and a secondary battery to which voltage is applied in a floating state for one year up to the SOC level of 60% have deterioration states at different levels as secondary batteries after one year has elapsed.

That is, the deterioration state of a secondary battery can be estimated based on how long the secondary battery has stayed in each SOC range, for example, with respect to each of the ranges of 10% such as 100% to 90%, 90% to 80%, and so on.

More specifically, when a secondary battery is put into operation for one year, the deterioration state of the secondary battery can be calculated provided that stay duration rates for the respective SOC ranges can be obtained in a manner such that the SOC is to stay at around 100% for 3 months, at around 80% for 3 months, at around 60% for 3 months, and at around 40% for 3 months.

For that reason, the charge/discharge controlling unit 23 functions as an allocation setting unit, monitors the individual stay duration rates for the respective SOC ranges of the power storage device 11A and the power storage device 12A, and performs control in such a manner as to adjust the individual stay duration rates for respective SOC ranges of the power storage device 11A and the power storage device 12A so as to equalize the expected periods that remain until the ends of the lifetimes thereof (in such a manner as to, instead of equalizing burdens thereon, change the burden ratio therebetween so as to equalize the periods that remain until the ends of the lifetimes thereof).

Next, when the stay duration rates for corresponding temperature ranges are used as the parameters in calculation of a deterioration state, it is generally known that a lifetime varies depending on stay duration rates for corresponding temperature ranges.

Specifically, for example, a secondary battery that has been used in an environment in which the temperature is 45 degrees Celsius and a secondary battery that has been used in an environment in which the temperature is 25 degrees Celsius have deterioration states of different levels as secondary batteries after one year has elapsed.

That is, the deterioration state can be estimated based on how long the temperature of the environment in which the secondary battery is used has stayed in each temperature range.

More specifically, when a secondary battery is put into operation for one year, the deterioration state of the secondary battery can be calculated provided that stay duration rates for respective temperature ranges can be obtained in a manner such that the temperature of the operation environment is to stay at around 45 degrees Celsius for 3 months, at around 25 degrees Celsius for 6 months, and at around zero degrees Celsius for 3 months.

For that reason, the charge/discharge controlling unit 23 functions as an allocation setting unit, monitors the individual stay duration rates for the respective temperature ranges of the power storage device 11A and the power storage device 12A, and performs control in such a manner as to adjust the individual stay duration rates for respective temperature ranges of the power storage device 11A and the power storage device 12A so as to equalize the expected periods that remain until the ends of the lifetimes thereof (in such a manner as to, instead of equalizing burdens thereon, change the burden ratio therebetween so as to equalize the periods that remain until the ends of the lifetimes thereof).

While the above description illustrates the case in which parameters are individually controlled, it is also possible to configure the embodiment so as to perform control by calculating the deterioration states with higher precision based on a plurality of parameters

Specifically, for example, the deterioration state thereof can be detected with higher precision even in a case where, with a secondary battery put into operation in accordance with a specific pattern of power with which the secondary battery is charged and discharged, it is difficult to detect the deterioration state based on determination using an individual parameter, such as a case where the internal resistance value thereof does not increase while the amount of storable energy therein decreases, or a case where the internal resistance value thereof increases while the amount of storable energy does not decrease.

The operation is described again with reference to the processing flowchart in FIG. 2.

Subsequently, when it is not the time to update the first deterioration state data D21 and the second deterioration state data D22, the charge/discharge controlling unit 23 reads out the most recent first deterioration state data D21 from the first deterioration state storing unit 21 and reads out the most recent second deterioration state data D22 from the second deterioration state storing unit 22 (step S12).

Subsequently, based on the first state detection data D11 and the second deterioration state data D22, the charge/discharge controlling unit 23 detects a demand status (the amount of power requested for discharging or the amount of power requested for charging) in the commercial system 13 (step S13).

Upon detecting the demand status in the commercial system 13, the charge/discharge controlling unit 23 determines, based on the first deterioration state data D21 and the second deterioration state data D22, whether the deterioration states need to be taken into consideration in the control of the large-capacity storage battery system 11 and the high-output storage battery system 12 (step S14).

Specifically, it is determined, based on the SOC or the SOH of the power storage device 11A or the power storage device 12A, whether a charging capacity, a charging current, a discharging capacity, or a discharging current needs to be limited.

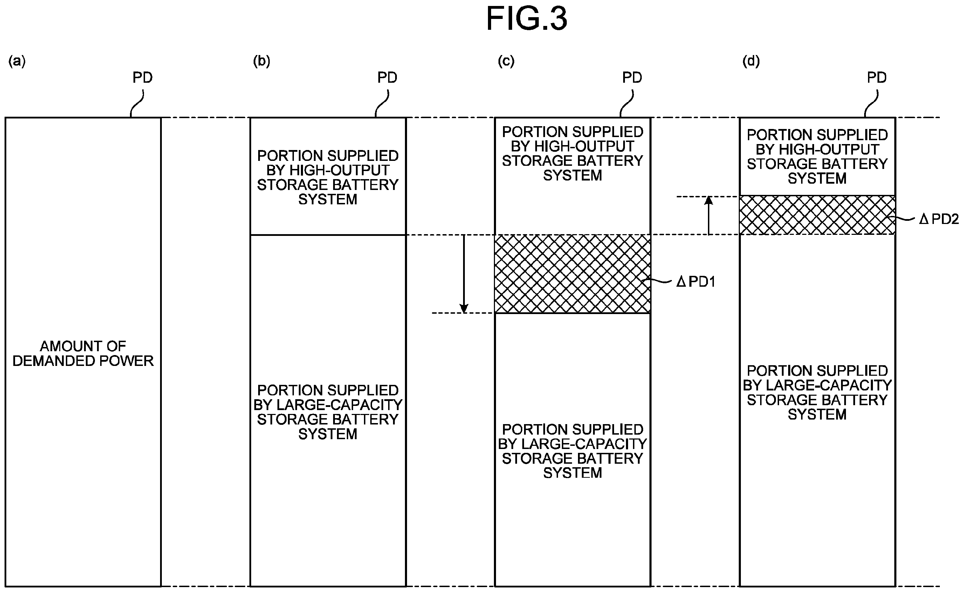

FIG. 3 is a diagram explaining the relations of the discharging capacity of the large-capacity storage battery system and the discharging capacity of the high-output storage battery system and an amount of demanded power.

In FIG. 3, the areas of individual rectangles that represent corresponding amounts of power are assumed to be proportionate to the corresponding amounts of power.

When an amount PD of demanded power at a certain point in time is as illustrated in (a) of FIG. 3, the proportions of the discharging capacities that the power storage device 11A in the large-capacity storage battery system 11 and the power storage device 12A in the high-output storage battery system 12 are assumed to have at the initial state of the power storage system 10 are assumed to be as illustrated in (b) of FIG. 3.

In such a case, when the power storage device 11A in the large-capacity storage battery system 11 is comparatively deteriorated and the power storage device 11A is to be protected, the power storage device 12A in the high-output storage battery system 12 is caused to output power that is increased, by an amount of power that corresponds to ΔPD1, from the power output thereby in (a) of FIG. 3, so that the amount of power that corresponds to the amount PD of demanded power is supplied in total, for example, as illustrated in (c) of FIG. 3.

As a result, the burden on the power storage device 11A decreases, whereby the lifetime of the power storage device 11A can be extended.

Likewise, when the power storage device 12A in the high-output storage battery system 12 is comparatively deteriorated and the power storage device 12A is to be protected, the power storage device 11A in the large-capacity storage battery system 11 is caused to output power that is increased, by an amount of power that corresponds to ΔPD2, from the power output thereby in (a) of FIG. 3, so that the amount of power that corresponds to the amount PD of demanded power is supplied in total, for example, as illustrated in (d) of FIG. 3.

As a result, the burden on the power storage device 12A decreases, whereby the lifetime of the power storage device 12A can be extended.

Accordingly, if the determination at step S14 indicates that the deterioration states do not need to be taken into consideration (No at step S14), the charge/discharge controlling unit 23 causes charging or discharging in accordance with the proportions of power capacities that the power storage device 11A in the large-capacity storage battery system 11 and the power storage device 12A in the high-output storage battery system 12 are assumed to have at the initial state (step S16), as illustrated in (b) of FIG. 3.

In contrast, if the determination at step S14 indicates that the deterioration states need to be taken into consideration (Yes at step S14), the charge/discharge controlling unit 23 determines whether the demand status is such that it is possible to take into consideration the deterioration states of the power storage device 11A in the large-capacity storage battery system 11 and the power storage device 12A in the high-output storage battery system 12 (step S15).

If, according to the determination at step S15, it is not possible to take into consideration the deterioration state of the storage battery device that has a burden placed on the charge-discharge capacity thereof that is the higher of respective burdens placed on the charge-discharge capacity of the power storage device 11A in the large-capacity storage battery system 11 and of the power storage device 12A in the high-output storage battery system 12 (No at step S15), the charge/discharge controlling unit 23 performs normal power supply allocation control without taking the deterioration states into consideration as illustrated in (b) of FIG. 3 (step S16).

In contrast, if, according to the determination at step S15, it is possible to take into consideration the deterioration state of the storage battery device that has a burden placed on the charge-discharge capacity thereof that is the higher of respective burdens placed on the charge-discharge capacity of the power storage device 11A in the large-capacity storage battery system 11 and of the power storage device 12A in the high-output storage battery system 12 (Yes at step S15), the charge/discharge controlling unit 23 performs power supply allocation control with the deterioration states taken into consideration as illustrated in (c) of FIG. 3 or (d) of FIG. 3 (step S17).

As described above, according to the present first embodiment, as a result of continuously performing the above-described control, the deterioration of the large-capacity storage battery system 11 and deterioration in the high-output storage battery system 12 can be equalized, whereby the lifetime of the power storage system 10 as a whole can be successfully extended.

While the above description illustrates the case in which the amount PD of demanded power is constant, the first embodiment is also applicable to a case in which the amount PD of demanded power changes.

### Second Embodiment

A second embodiment is described next.

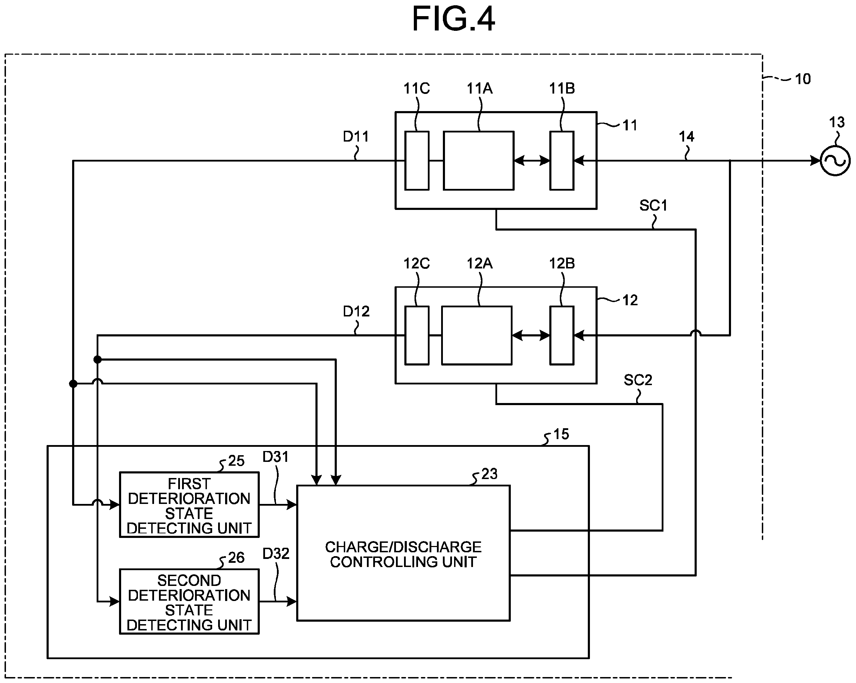

FIG. 4 is a schematic configuration block diagram of a power storage system in the second embodiment.

A difference in FIG. 4 from the first embodiment in FIG. 1 is that a first deterioration state detecting unit 25 configured to calculate the deterioration state of the large-capacity storage battery system 11 and a second deterioration state detecting unit 26 configured to calculate the deterioration state of the high-output storage battery system 12 are included.

In the above configuration, based on the first state detection data D11 output by the state detecting unit 11C, the first deterioration state detecting unit 25 calculates the deterioration state of the power storage device 11A on a real-time basis and outputs the calculated deterioration state of the power storage device 11A, as first deterioration state detection data D31, to the charge/discharge controlling unit 23.

Likewise, based on the second state detection data D12 output by the state detecting unit 12C, the second deterioration state detecting unit 26 calculates the deterioration state of the power storage device 12A on a real-time basis and outputs the calculated deterioration state of the power storage device 12A, as second deterioration state detection data D32, to the charge/discharge controlling unit 23.

As a result, the charge/discharge controlling unit 23 functions as an allocation setting unit, can equalize the deterioration of the large-capacity storage battery system 11 and deterioration in the high-output storage battery system 12, and can successfully extend the lifetime of the power storage system 10 as a whole.

Operation in the second embodiment is described next.

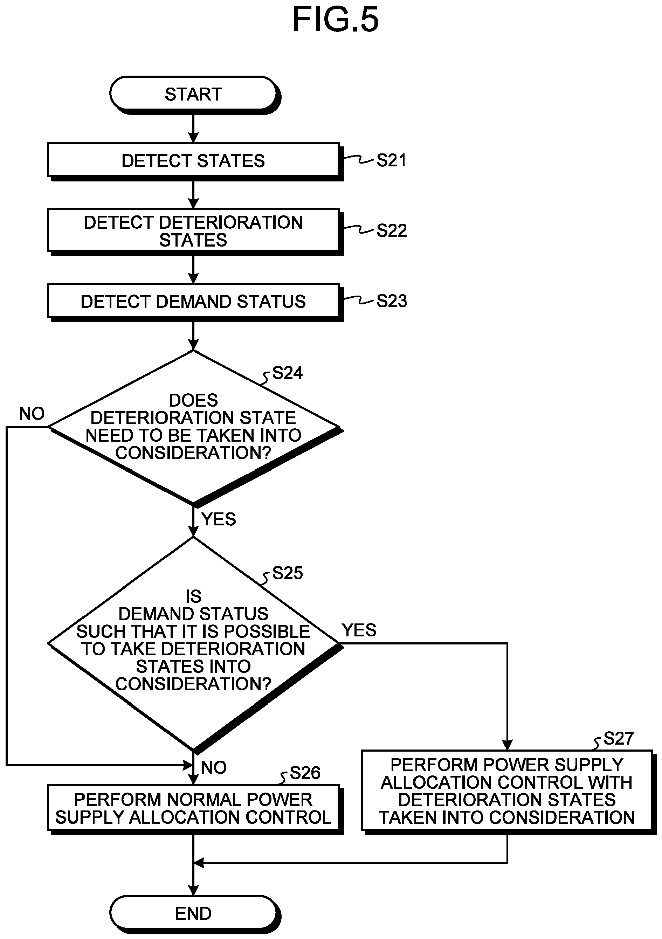

FIG. 5 is a processing flowchart for the power storage system in the second embodiment.

At the start, state detection processing is performed in the power storage system 10, and the state detecting unit 11C detects the power storage capacity, the temperature, the input and output currents, and the input and output voltages of the large-capacity storage battery system 11, and the state (such as the SOC or the SOH) of the power storage device 11A and outputs such detected information, as the first state detection data D11, to the charge/discharge controlling unit 23. Likewise, the state detecting unit 12C detects the power storage capacity, the temperature, the input and output currents, and the input and output voltages of the high-output storage battery system 12, and the state (such as the SOC or the SOH) of the power storage device 12A and outputs the detected information as the second state detection data D12 to the charge/discharge controlling unit 23 (step S21).

As a result of these parts of this processing, the charge/discharge controlling unit 23 detects the state of the system interconnection with the commercial system 13 or the state of charge of the large-capacity storage battery system 11 or the high-output storage battery system 12 in connection with power supply from the commercial system 13.

In parallel to the state detection processing, the first deterioration state detecting unit 25 calculates the deterioration state of the power storage device 11A on a real-time basis based on the first state detection data D11 output by the state detecting unit 11C and outputs the calculated deterioration state of the power storage device 11A, as the first deterioration state detection data D31, to the charge/discharge controlling unit 23, and the second deterioration state detecting unit 26 calculates the deterioration state of the power storage device 12A on a real-time basis based on the second state detection data D12 output by the state detecting unit 12C and outputs the calculated deterioration state of the power storage device 12A, as the second deterioration state detection data D32, to the charge/discharge controlling unit 23 (step S22).

As a result of these parts of the processing, based on the first state detection data D11 and the second deterioration state data D22, the charge/discharge controlling unit 23 detects a demand status (the amount of power requested for discharging or the amount of power requested for charging) in the commercial system 13 (step S23) .

Upon detecting the demand status in the commercial system 13, the charge/discharge controlling unit 23 determines, based on the first deterioration state data D21 and the second deterioration state data D22, whether the deterioration states need to be taken into consideration in the control of the large-capacity storage battery system 11 and the high-output storage battery system 12 (step S24).

If the determination at step S24 indicates that the deterioration states do not need to be taken into consideration (No at step S24), the charge/discharge controlling unit 23 causes charging or discharging in accordance with the proportions of power capacities that the power storage device 11A in the large-capacity storage battery system 11 and the power storage device 12A in the high-output storage battery system 12 are assumed to have at the initial state (step S26), as illustrated in (b) of FIG. 3.

If the determination at step S24 indicates that the deterioration states need to be taken into consideration (Yes at step S24), the charge/discharge controlling unit 23 determines whether the demand status is such that it is possible to take into consideration the deterioration states of the power storage device 11A in the large-capacity storage battery system 11 and the power storage device 12A in the high-output storage battery system 12 (step S25).

If, according to the determination at step S25, it is not possible to take into consideration the deterioration state of the storage battery device that has a burden placed on the charge-discharge capacity thereof that is the higher of respective burdens placed on the charge-discharge capacity of the power storage device 11A in the large-capacity storage battery system 11 and of the power storage device 12A in the high-output storage battery system 12 (No at step S25), the charge/discharge controlling unit 23 performs normal power supply allocation control without taking the deterioration states into consideration as illustrated in (b) of FIG. 3 (step S26).

In contrast, if, according to the determination at step S25, it is possible to take into consideration the deterioration state of the storage battery device that has a burden placed on the charge-discharge capacity thereof that is the higher of respective burdens placed on the charge-discharge capacity of the power storage device 11A in the large-capacity storage battery system 11 and of the power storage device 12A in the high-output storage battery system 12 (Yes at step S25), the charge/discharge controlling unit 23 performs power supply allocation control with the deterioration states taken into consideration as illustrated in (c) of FIG. 3 or (d) of FIG. 3 (step S27).

As described above, according to the present second embodiment, not only the same effect as the effect produced by the first embodiment can be produced, control in which the deterioration state of a power storage device is reflected on a real-time basis can be performed, and the deterioration of the large-capacity storage battery system 11 and the deterioration of the high-output storage battery system 12 can be equalized with higher precision, whereby the lifetime of the power storage system 10 as a whole can be successfully extended.

While the above description illustrates the case in which the amount PD of demanded power is constant, the second embodiment is also applicable to a case in which the amount PD of demanded power sequentially changes.

In such a case, the proportions to the amount PD of demanded power may be controlled in the same manner as in the above described case, or power for charging or discharging that corresponds to demanded power may be assigned to one of the power storage systems within a range that can be tolerated by one of the large-capacity storage battery system 11 and the high-output storage battery system 12 that is not likely to deteriorate.

As described above, according to each of the embodiments, the extension of the lifetime of a power storage system as a whole can be facilitated, controlling power, with which a large-capacity storage battery system and a large-power storage battery system are charged and discharged, so as to intentionally accelerate the deterioration of one of the storage battery systems can extend the lifetime of the more expensive one of the battery systems, and lifetime management in accordance with an inspection cycle can be implemented whereby an operation cost for a system as a whole can be reduced.

The power storage control device in any of the present embodiments includes a control device such as a central processing unit (CPU), a storage device such as a read only memory (ROM) or a random-access memory (RAM), an external storage device such as a hard disk drive (HDD) or a compact disc (CD) drive device, a display device configured to display various kinds of information, and an input device for inputting various kinds of information, and thus has a hardware configuration using a normal computer.

A computer program to be executed on the power storage control device in any of the present embodiments is provided as a file in an installable format or an executable format while being stored in a computer-readable recording medium such as a compact disc read-only memory (CD-ROM), a semiconductor storage device such as a universal serial bus (USB) memory, or a digital versatile disc (DVD).

A computer program to be executed on the power storage control device in any of the present embodiments may be configured so as to be provided by being stored on a computer connected to a network such as the Internet and being downloaded via the network. A computer program to be executed on the power storage control device in any of the present embodiments may be configured so as to be provided or distributed via a network such as the Internet.

A computer program to be executed on the power storage control device in any of the present embodiments may be configured to be provided by being previously embedded in a ROM or the like.

A computer program to be executed on the power storage control device in any of the present embodiments has a modular configuration that includes the above-described individual units (the deterioration state detecting unit, a demanded-power amount detecting unit, the allocation setting unit); and the actual hardware operates in such a manner that the deterioration state detecting unit, the demanded-power amount detecting unit, and the allocation setting unit are generated on a main storage unit as a result of having the individual units loaded on the main storage device when a CPU (a processor) reads the computer program from the above storage medium and executes the computer program.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A power storage control device that is used for a power storage system in which a large-capacity storage battery system including a first power storage device and a high-output storage battery system including a second power storage device are combined, the power storage control device comprising:
a deterioration state detecting unit configured to detect respective deterioration states of the first power storage device and the second power storage device;
a demanded-power amount detecting unit configured to detect an amount of demanded power, the amount of demanded power being an amount of power that the power storage system is requested to be charged or discharged with; and
an allocation setting unit configured to, based on the deterioration states of the first power storage device and the second power storage device and the amount of demanded power, set respective amounts of power to be allocated to the first power storage device and the second power storage device.

2. The power storage control device according to claim 1, wherein the deterioration state detecting unit sets up parameters including amounts of storable energy, internal resistance values, numbers of charge-discharge cycles, and stay duration rates for SOC ranges or stay duration rates for temperature ranges of the first power storage device and the second power storage device, and calculates the deterioration states based on at least one of the parameters.

3. The power storage control device according to claim 1 or 2, wherein, based on the detected deterioration states, the allocation setting unit sets the amounts of power to be allocated to the first power storage device and the second power storage device in such a manner that periods of lifetimes of the first power storage device and the second power storage device are same.

4. The power storage control device according to any one of claims 1 to 3, wherein, based on the detected deterioration states, the allocation setting unit sets the amounts of power to be allocated to the first power storage device and the second power storage device in such a manner that a certain power storage device of the first power storage device and the second power storage device reaches a lifetime thereof in first.

5. A power storage system, comprising:
a large-capacity storage battery system including a first power storage device;
a high-output storage battery system including a second power storage device that has a smaller capacity than and a charge-discharge capacity per unit time higher than the large-capacity storage battery system; and
a power storage control device configured to control the large-capacity storage battery system and the high-output storage battery system, wherein
the power storage control device comprises:
a deterioration state detecting unit configured to detect respective deterioration states of the first power storage device and the second power storage device;
a demanded-power amount detecting unit configured to detect an amount of demanded power, the amount of demanded power being an amount of power that the power storage system is requested to be charged or discharged with; and
an allocation setting unit configured to, based on the deterioration states of the first power storage device and the second power storage device and the amount of demanded power, set respective amounts of power to be allocated to the first power storage device and the second power storage device.

6. A control method to be executed in a power storage control device that is used for a power storage system in which a large-capacity storage battery system including a first power storage device and a high-output storage battery system including a second power storage device are combined, the control method comprising:
detecting respective deterioration states of the first power storage device and the second power storage device;
detecting an amount of demanded power, the amount of demanded power being an amount of power that the power storage system is requested to be charged or discharged with; and
based on the deterioration states of the first power storage device and the second power storage device and the amount of demanded power, setting respective amounts of power to be allocated to the first power storage device and the second power storage device.
